# EUROPEAN PATENT APPLICATION

(11) **EP 4 835 499 A1**
(43) Date of publication of application: **04.11.2026**
(21) Application number: 26157713.4
(22) Date of filing: 10.02.2026
(51) Int. Cl.: G01R 27/20, G01R 31/389

(54) **METHOD AND APPARATUS FOR INSPECTING JOINT**

(30) Priority: 30.04.2025 KR 20250057265
(71) Applicant: SAMSUNG SDI CO., LTD., Yongin-si, Gyeonggi-do 17084 (KR)
(72) Inventor: JAEHOON, CHOI, 17084 YONGIN-SI (KR); BYUNGJOO, JEONG, 17084 YONGIN-SI (KR); JUHWAN, KO, 17084 YONGIN-SI (KR)
(74) Representative: Regimbeau

(57) **Abstract**

A method of inspecting a joint, the method including calculating a first measurement value of a battery bank unit, which includes a plurality of battery cells, based on a resistance of each of the plurality of battery cells, calculating a second measurement value of the battery bank unit based on current applied to a battery module including a plurality of battery banks, and determining whether there is an abnormality in a joint for the battery bank unit based on a difference between the first measurement value and the second measurement value, the difference being compared to a threshold value.

## Description

### TECHNICAL FIELD

The disclosure relates to a method and apparatus for inspecting a joint.

### BACKGROUND

Unlike a primary battery which is not chargeable, a secondary battery is a battery that can be repeatedly charged and discharged. The secondary battery is used as a power source for various types of electronic devices.

A secondary battery may be used in the form of a single cell or in the form of multiple cells electrically connected to each other, depending on the type of electronic device. For example, while small devices such as mobile phones can operate for a specific period of time with the output and capacity of a single secondary battery, in cases where high output and high capacity are required, such as in electric vehicles, a plurality of secondary batteries may be connected in series, in parallel, or in series-parallel.

A battery pack may be configured to include cylindrical, prismatic, or pouch cells. The battery pack includes a plurality of battery cells. The plurality of battery cells may be electrically connected in a series-parallel configuration. Each battery cell includes electrodes. A current collector called a bus bar is provided so that the plurality of battery cells are electrically connected.

The above-described information disclosed in the background technology of this disclosure is only intended to improve understanding of the background of the present disclosure and therefore may include information that does not constitute related art.

### SUMMARY

The disclosure relates to a method and an apparatus for inspecting a joint as defined in the appended claims.

Embodiments include a method of inspecting a joint, the method including calculating a first measurement value of a battery bank unit, which includes a plurality of battery cells, based on a resistance of each of the plurality of battery cells, calculating a second measurement value of the battery bank unit based on current applied to a battery module including a plurality of battery banks, and determining whether there is an abnormality in a joint for the battery bank unit based on a difference between the first measurement value and the second measurement value, the difference being compared to a threshold value.

Calculating the first measurement value may include obtaining the resistance of each of the plurality of battery cells, and calculating a measurement value related to at least one of voltage and resistance of the battery bank unit based on a measured current and/or a measured voltage, respectively.

The resistance may be measured at a point in time when the plurality of battery cells are interconnected and constitute the battery bank unit.

Calculating the second measurement value may include measuring a voltage of the battery bank unit, resulting in a measured voltage, and calculating a resistance of the battery bank unit based on the measured voltage.

Calculating the second measurement value may include measuring a current for at least one of the plurality of battery cells, resulting in a measured current, and calculating a measurement value related to at least one of voltage and resistance of the battery bank unit based on the measured current.

The first measurement value and the second measurement value may be a same voltage or a same resistance.

The threshold value may be a predetermined value.

A unit of the threshold value may be determined based on the units of the first measurement value and the second measurement value, resulting in a determined unit, and the threshold value may include a predetermined value based on the determined unit.

Embodiments include an apparatus for inspecting a joint, the apparatus including at least one memory, and at least one processor, wherein the processor is configured to calculate a first measurement value of a battery bank unit, which includes a plurality of battery cells, based on a resistance of each of the plurality of battery cells, calculate a second measurement value of the battery bank unit based on current applied to a battery module including a plurality of battery bank units, and determine whether there is an abnormality in a joint for the battery bank unit based on a difference between the first measurement value and the second measurement value, the difference being compared to a threshold value.

The processor may be further configured to obtain the resistance of each of the plurality of battery cells, and calculate a measurement value related to at least one of voltage and resistance of the battery bank unit based on a measured current and/or a measured voltage, respectively.

The resistance may be measured at a point in time when the plurality of battery cells are interconnected and constitute the plurality of battery bank units.

The processor may be further configured to measure a voltage of the battery bank unit, resulting in a measured voltage, and calculate a resistance of the battery bank unit based on the measured voltage.

The processor may be further configured to measure a current for at least one of the plurality of battery cells, resulting in a measured current, and calculate a measurement value related to at least one of voltage and resistance of the battery bank unit based on the measured current.

Units of the first measurement value and the second measurement value may be a same voltage or a same resistance.

The threshold value may be a predetermined value.

A unit of the threshold value may be determined based on the unit of the first measurement value and the second measurement value, resulting in a determined unit, and the threshold value may be a predetermined value based on the determined unit.

A computer-readable recording medium having recorded thereon a program for causing a computer to execute the method.

### BRIEF DESCRIPTION OF THE DRAWINGS

Features will become apparent to those of ordinary skill in the art by describing in detail exemplary embodiments with reference to the attached drawings, in which:
FIG. 1 is a schematic diagram of a battery system for inspecting a joint abnormality between a cell and a bus bar according to an embodiment;
FIG. 2 is a block diagram illustrating an example of an internal configuration of an apparatus for inspecting a joint according to an embodiment;
FIG. 3 is a flowchart illustrating an example of a method of calculating a first measurement value according to an embodiment;
FIG. 4 is a flowchart illustrating an example of a method of calculating a second measurement value according to an embodiment;
FIG. 5 is a flowchart illustrating an example of a method of determining whether there is an abnormality in a joint between a cell and a bus bar according to an embodiment; and
FIG. 6 is a flowchart illustrating an example of a method of inspecting a joint method according to an embodiment.

### DETAILED DESCRIPTION

Example embodiments will now be described more fully hereinafter with reference to the accompanying drawings; however, they may be embodied in different forms and should not be construed as limited to the embodiments set forth herein. Rather, these embodiments are provided so that this disclosure will be thorough and complete, and will fully convey exemplary implementations to those skilled in the art.

In the drawing figures, the dimensions of layers and regions may be exaggerated for clarity of illustration. It will also be understood that when a layer or element is referred to as being "on" another layer or substrate, it can be directly on the other layer or substrate, or intervening layers may also be present. Further, it will be understood that when a layer is referred to as being "under" another layer, it can be directly under, and one or more intervening layers may also be present. In addition, it will also be understood that when a layer is referred to as being "between" two layers, it can be the only layer between the two layers, or one or more intervening layers may also be present. Like reference numerals refer to like elements throughout.

The advantages and features of the disclosure and methods to achieve them will be apparent from the embodiments described below in detail in conjunction with the accompanying drawings. However, the description of particular embodiments is not intended to limit the disclosure to the particular embodiments disclosed herein, but on the contrary, it should be understood that the disclosure is to cover all modifications, equivalents and alternatives falling within the scope of the present disclosure. The embodiments disclosed below are provided so that the disclosure will be thorough and complete, and also to provide a more complete understanding of the scope of the disclosure to those of ordinary skill in the art. In the interest of clarity, not all details of the relevant art are described in detail in the present specification if it is determined that such details are not necessary to obtain a complete understanding of the disclosure.

The terminology used herein is used for the purpose of describing particular embodiments only and is not intended to be limiting. As used herein, the singular forms "a," "an," and "the" are intended to include plural forms as well, unless the context clearly dictates otherwise. The terms "comprises," "comprising," "includes," "including," "containing," "has," "having" or other variations thereof are inclusive and therefore specify the presence of stated features, integers, steps, operations, elements, and/or components, but do not preclude the presence or addition of one or more other features, integers, steps, operations, elements, components, and/or groups thereof.

Some embodiments of the disclosure may be described in terms of functional block components and various processing steps. Some or all of such functional blocks may be realized by any number of hardware and/or software components configured to perform the specified functions. For example, functional blocks according to the disclosure may be realized by one or more microprocessors (e.g., one or more processors) or by circuit components for a given function. In addition, for example, the functional blocks of the disclosure may be implemented with various programming or scripting languages. The functional blocks may be implemented in algorithms that are executed on one or more processors. Furthermore, the disclosure described herein may employ any number of techniques according to the related art for electronics configuration, signal processing and/or control, data processing, and the like. The terms "mechanism", "element", "means", and "configuration" are used broadly and are not limited to mechanical or physical embodiments.

Furthermore, the connecting lines, or connectors shown in the drawings presented are intended to represent exemplary functional relationships and/or physical or logical couplings between various elements. It should be noted that many alternative or additional functional relationships, physical connections, or logical connections may be present in a practical apparatus.

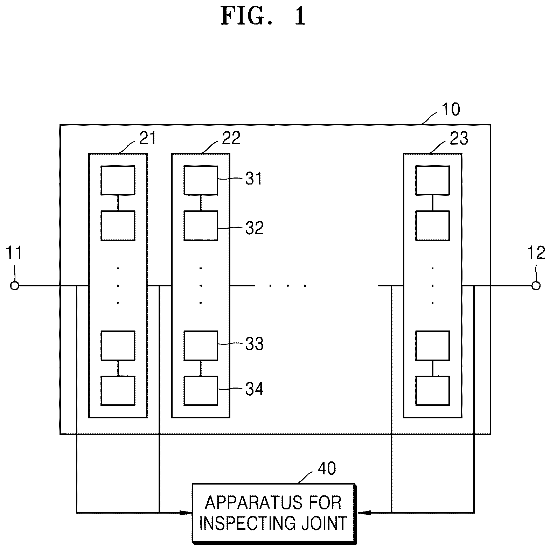

FIG. 1 is a schematic diagram of a battery system for inspecting a joint abnormality between a cell and a bus bar according to an embodiment.

Referring to FIG. 1, a battery system according to an embodiment of the disclosure may include one or more battery modules 10 and an apparatus 40 for inspecting a joint.

For example, the apparatus 40 for inspecting a joint may be connected to one or more battery banks 21, 22, and 23 included in the battery module 10, and may inspect whether there is a joint abnormality in the connected battery banks 21, 22, and 23. In other words, the apparatus 40 according to an embodiment of the disclosure may be understood to be capable of inspecting joint abnormalities for each battery bank.

The battery module 10, which serves to store power, may include a plurality of battery cells 31, 32, 33, and 34 that are electrically interconnected between a first terminal 11 and a second terminal 12. For example, the battery cells 31, 32, 33, and 34 may be connected in series, in parallel, or in a combination of series and parallel. For example, each of the battery cells 31, 32, 33, and 34 may have the same capacity and may discharge and be charged with the same amount of current. However, in practice, the internal states of the battery cells 31, 32, 33, and 34 may differ from one another. For example, each of the battery cells 31, 32, 33, and 34 may have different internal resistance and electromotive force.

The battery module 10 may include a plurality of battery banks 21, 22, and 23, and each of the battery banks 21, 22, and 23 may include a plurality of battery cells 31, 32, 33, and 34. In this disclosure, a battery bank 21, 22, or 23 may refer to a group of battery cells 31, 32, 33, and 34 connected in parallel. For example, when the battery module 10 includes 50 × 20 battery cells, a group of 26 battery cells connected in parallel may form one battery bank, and a total of 38 battery banks connected in series may constitute the battery module 10.

The battery cells 31, 32, 33, and 34 may include rechargeable secondary batteries. For example, the battery cells 31, 32, 33, and 34 may include a nickelcadmium battery, a lead-acid battery, a nickel-metal hydride (NiMH) battery, a lithium-ion battery, a lithium-polymer battery, or the like. For example, the number of battery cells 31, 32, 33, and 34 constituting the battery module 10 may be determined according to the capacity, output voltage, and output current required for the battery module 10 (or battery).

Although FIG. 1 illustrates a single of the battery module 10, a plurality of battery modules 10 may be connected in parallel and/or in series. For example, the battery module 10 may be connected to another battery module via the first terminal 11 and/or the second terminal 12. For example, a plurality of battery modules 10 connected in parallel and/or in series may constitute a battery pack. In an embodiment, the apparatus 40 for inspecting a joint may be connected to one or more battery banks included in the battery pack and may inspect whether there is a joint abnormality in the connected battery banks.

In an embodiment, the apparatus 40 may include a voltage measuring unit and/or a current measuring unit.

In an embodiment, the voltage measuring unit may be connected to both terminals of at least one of the battery banks 21, 22, and 23 in use, and may measure the voltage of the connected battery bank. For example, since the plurality of battery cells 31, 32, 33, and 34 included in the battery bank 22 are connected in parallel, the measured voltage of the battery bank 22 may be the same as the voltage of the plurality of battery cells 31, 32, 33, and 34.

In an embodiment, the current measuring unit may measure the current of any one of the battery cells included in the battery banks 21, 22, and 23 in use. For example, the current measuring unit may be connected to both terminals of a battery cell 31 included in the battery bank 22 and may measure the current of the connected battery cell. In an embodiment, the measured current of the battery cell may be used to calculate a current measurement value of the battery bank. For example, when the internal resistance of each of the plurality of battery cells 31, 32, 33, and 34 included in the battery bank 22 is the same, the current for each of the plurality of battery cells 31, 32, 33, and 34 may also be the same. In another example, when the ratio between the internal resistances of the plurality of battery cells 31, 32, 33, and 34 included in the battery bank 22 is known, the current for each of the plurality of battery cells 31, 32, 33, and 34 may be inversely proportional to the resistance. Since the current measurement value of the battery bank 22 unit may be calculated by summing the currents of each of the plurality of battery cells 31, 32, 33, and 34, the current measurement value of the battery bank 22 unit may be calculated by measuring the current of any one battery cell 31 included in the battery bank 22.

As described above, the plurality of battery cells 31, 32, 33, and 34 included in the battery module 10 may be electrically connected. Each of the battery cells 31, 32, 33, and 34 may include electrodes, and a current collector called a bus bar may be provided to electrically connect the plurality of battery cells 31, 32, 33, and 34.

The bus bar may be electrically connected to the battery cells. For example, among the methods for electrically connecting the bus bar and the battery cells, ultrasonic wire bonding (WB) may be applied. For example, when ultrasonic wire bonding is applied, both electrodes of a battery cell may each be bonded to the bus bar.

Here, in case that either of the two electrodes of the battery cell is abnormally bonded to the bus bar, the battery cell cannot be regarded as being electrically connected to the bus bar. A battery cell not connected to the bus bar cannot be regarded as being connected to a load and/or a charging device. Accordingly, a problem may occur in which the amount of current discharged to the load or the amount of power charged from the charging device at the battery bank unit or battery module unit deviates from the normal range.

To solve the above problem, a method of inspecting a joint is disclosed below.

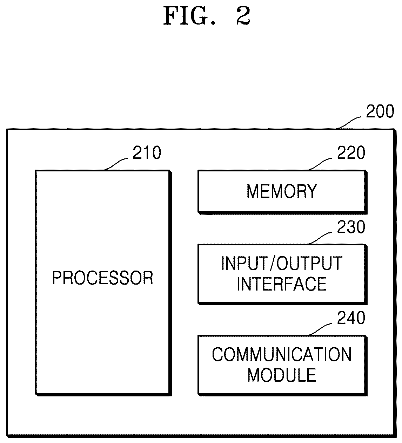

FIG. 2 is a block diagram illustrating an example of an internal configuration of an apparatus for inspecting a joint according to an embodiment.

Referring to FIG. 2, an apparatus for inspecting a joint may include a processor 210, a memory 220, an input/output interface 230, and a communication module 240. For convenience of explanation, only components related to the method of inspecting a joint are illustrated in FIG. 2. Accordingly, in addition to the components shown in FIG. 2, other general-purpose components may also be included in the apparatus 200. In addition, one of ordinary skill in the art will know the processor 210, the memory 220, the input/output interface 230, and the communication module 240 illustrated in FIG. 2 may also be implemented as independent devices.

The processor 210 may process instructions of a computer program by performing basic arithmetic, logic, and input/output operations. Here, the instructions may be provided from the memory 220 or an external device. Additionally, the processor 210 may control the overall operation of other components included in the apparatus 200.

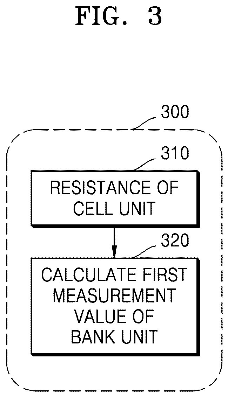

For example, the processor 210 may control at least part of the operations of the apparatus 200, which will be described below with reference to FIGS. 3 to 6.

The processor 210 may be implemented as an array of a plurality of logic gates, or may be implemented as a combination of a general-purpose microprocessor and a memory storing a program executable by the microprocessor. For example, the processor 210 may be implemented as a general-purpose processor, a central processing unit (CPU), a microprocessor, a digital signal processor (DSP), a controller, a microcontroller, a state machine, and the like. In some environments, the processor 210 may include an application-specific integrated circuit (ASIC), a programmable logic device (PLD), a field-programmable gate array (FPGA), and the like. For example, processor 210 may refer to a combination of processing devices, such as a combination of a DSP and a microprocessor, a combination of a plurality of microprocessors, a combination of one or more microprocessors combined with a DSP core, or a combination of any other such configurations.

The memory 220 may include any non-transitory computer-readable recording medium. For example, the memory 220 may include a permanent mass storage device, such as random-access memory (RAM), read-only memory (ROM), a disk drive, a solid-state drive (SSD), or flash memory. As another example, the permanent mass storage device, such as ROM, an SSD, flash memory, or a disk drive, may be a permanent storage device separate from the memory. Also, the memory 220 may store an operating system (OS) and at least one piece of program code (e.g., code for the processor 210 to perform an operation to be described below with reference to FIGS. 3 to 6).

According to an embodiment, the memory 220 may store the internal resistance of each of the plurality of battery cells. For example, the internal resistance of each of the plurality of battery cells, which is input from a user through the input/output interface 230 or received from an external device using the communication module 240, may be stored in the memory 220. The details will be described below.

These software components may be loaded from a computer-readable recording medium separate from the memory 220. The separate computer-readable recording medium may be a recording medium that may be directly connected to the apparatus 200, and may include, for example, a computer-readable recording medium, such as a floppy drive, a disk, a tape, a digital video disc (DVD)/compact disc ROM (CD-ROM) drive, or a memory card. In other embodiments, the software components may be loaded into the memory 220 through the communication module 240 rather than a computer-readable recording medium. For example, at least one program may be loaded into the memory 220 on the basis of a computer program (e.g., a computer program for the processor 210 to perform an operation to be described below with reference to FIGS. 3 to 6) installed by files provided via the communication module 240 by developers or a file distribution system that distributes installation files of applications.

The input/output interface 230 may be a means for an interface with a device (e.g., a keyboard or a mouse) for input or output that may be connected to the apparatus 200 or included in the apparatus 200. Although FIG. 2 illustrates the input/output interface 230 as being implemented as an element separately from the processor 210, but the input/output interface 230 may be configured to be included in the processor 210.

The communication module 240 may provide a configuration or function for the apparatus 200 to communicate with an external device (e.g., an external apparatus or an external server) through a network. For example, a control signal, a command, data, and the like provided under control of the processor 210 may be transmitted to an external device through the communication module 240 and a network.

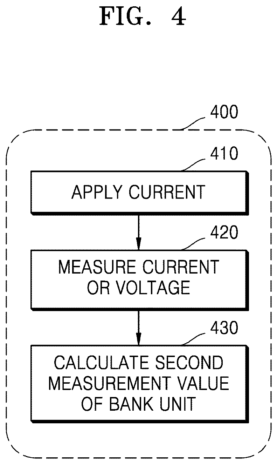

FIG. 3 is a flowchart illustrating an example of a method of calculating a first measurement value according to an embodiment, and FIG. 4 is a flowchart illustrating an example of a method of calculating a second measurement value according to an embodiment.

In the disclosure, the first measurement value and the second measurement value refer to measurement values that serve as a basis for inspecting whether there is an abnormality in the joint between a battery cell and a bus bar.

In addition, in the disclosure, the first measurement value and the second measurement value refer to measurement values of the battery bank unit. In other words, the apparatus for inspecting a joint in the disclosure may inspect joint abnormalities for each battery bank unit, rather than for each battery cell unit or each battery module unit.

First, a method 300 of calculating the first measurement value according to an embodiment will be described with reference to FIG. 3.

The apparatus for inspecting a joint may obtain the resistance of each battery cell unit (310). In the disclosure, the resistance of the battery cell unit refers to the resistance measured by an external device other than the joint inspection apparatus itself. For example, the apparatus may receive the cell-unit resistance input from the user or from an external device.

In an embodiment, the apparatus may store resistances of individual battery cell units. In an embodiment, the apparatus may classify and store the resistances of battery cell units by battery bank unit. In another embodiment, the apparatus may calculate the average resistance of each battery bank unit by averaging the resistances of the battery cell units and store the average resistance of the battery bank unit.

In an embodiment, the resistance of a battery cell unit may be a resistance measured at the point in time when the plurality of battery cells are interconnected to constitute a battery bank. In other words, the resistance of the battery cell unit may be the resistance measured during a series of processes in which a plurality of battery cells are assembled into a battery bank (or battery module).

The apparatus may calculate a first measurement value of a battery bank unit based on the resistance of the battery cell unit (320).

In an embodiment, the unit of the first measurement value may be either voltage or resistance. In an embodiment of the disclosure, since the unit of the first measurement value may be the same as the unit of the second measurement value, the unit of the first measurement value may be determined in advance. For example, the apparatus may have the unit of the first measurement value input by the user in advance (e.g., the first measurement value may be predetermined).

In an embodiment, the apparatus may store the first measurements. For example, when the battery module includes N battery banks, the apparatus may store first measurement values for each of the N battery banks. In an embodiment, the apparatus may calculate an average of the first measurement values corresponding to the plurality of battery banks. Additionally, the apparatus may normalize the first measurement values of the respective battery banks using the average measurement value, and may store the normalized first measurement values.

Hereinafter, a method 400 of calculating a second measurement value according to an embodiment will be described with reference to FIG. 4.

The apparatus for inspecting a joint (e.g., a joint between a battery cell and a bus bar) may apply current to the battery bank (410). More specifically, in a case where a plurality of battery banks constitute a battery module, it may be understood that current is applied to the battery module. Based on the supplied current, charging of the plurality of battery cells included in the battery bank may be performed.

The apparatus may be connected to the battery bank and may measure current or voltage (420). More specifically, the apparatus may measure a voltage of the battery bank unit or the current of the battery cell unit. In an embodiment, the apparatus may measure voltage or current based on the unit of the second measurement value. As described above, the unit of the second measurement value may be the same as the unit of the first measurement value and may be preset (e.g., predetermined) by the user. For example, the unit of the second measurement value may be set to at least one of voltage, current, or resistance.

The apparatus may calculate a second measurement value of the battery bank unit based on the measured current or the measured voltage (430).

In an embodiment, when the unit of the second measurement value is set to resistance, the apparatus may calculate the resistance of the battery bank unit based on the voltage measured of the battery bank unit.

In another embodiment, when the unit of the second measurement value is set to voltage, the apparatus may use the voltage measured of the battery bank unit as the second measurement value, or calculate the voltage of the battery bank unit based on the current measured of the battery cell unit.

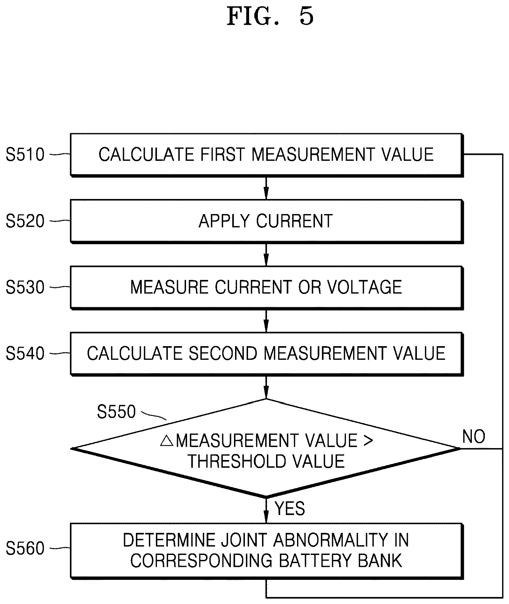

FIG. 5 is a flowchart illustrating an example of a method of determining whether there is an abnormality in a joint between a cell and a bus bar according to an embodiment.

Referring to FIG. 5, a method of inspecting whether there is a joint abnormality for each battery bank according to an embodiment of the disclosure is described. For convenience of explanation, it is assumed that a battery bank without any joint abnormality includes five battery cells, and that the internal resistance of each battery cell is 1. In addition, for convenience of explanation, it is assumed that the battery bank subject to joint abnormality inspection has a joint abnormality in one of its battery cells.

The apparatus for inspecting a joint may calculate a first measurement value of a battery bank unit based on the internal resistance of the battery cells (S510).

For example, when the unit of the first measurement value is resistance, the first measurement value may be calculated as 0.2 since it corresponds to the total resistance of the five battery cells connected in parallel. In another example, when the unit of the first measurement value is voltage, the first measurement value may be calculated as I × 0.2 (the total resistance of the battery cells). Here, the current "I" refers to the current of the battery bank unit, and may be the same value as the current supplied to the battery bank for calculating the second measurement value.

After storing the first measurement value, the apparatus may apply current to the battery module to calculate the second measurement value (S520). For example, the apparatus may calculate the current supplied to the battery bank based on the current applied to the battery module. For example, when the battery module includes 10 battery banks and a current of 100 A is applied, a current of 10 A may be supplied to one battery bank.

The apparatus may measure voltage of the battery bank unit or the current of the battery cell unit (S530).

For example, the apparatus may measure the voltage of a battery bank unit as 2.5 V. In other embodiments, the apparatus may measure the current of each battery cell unit as 2.5 A.

The apparatus may calculate a second measurement value of the battery bank unit based on the measured current or measured voltage (S540).

For example, when the unit of the second measurement value is voltage, the second measurement value may be calculated as 2.5 V. In another example, when the unit of the second measurement value is resistance, the apparatus may calculate the resistance of the battery bank unit as 0.25 based on the measured voltage value (2.5 V) and the supplied current (10 A). In yet another example, the apparatus may calculate the voltage (2.5 V) of each bank unit using the measured current (2.5 A), and calculate the resistance of the battery bank unit as 0.25 based on the voltage (2.5 V) of each bank unit and the supplied current (10 A).

The apparatus may compare the difference between the first measurement value and the second measurement value with a threshold value (S550), and may determine whether there is a joint abnormality in the battery bank based on the comparison result (S560). Here, the threshold value may be a value preset by the user based on experimentation (e.g., a predetermined threshold value). Accordingly, the apparatus may compare the difference between the first measurement value and the second measurement value with a preset threshold value, and when the difference between the first measurement value and the second measurement value exceeds the threshold value, it may determine that a joint abnormality exists in the corresponding battery bank.

For example, when the units of the first measurement value and the second measurement value are voltage, the difference between the first measurement value and the second measurement value may be calculated as 0.5 V. For example, when the threshold value for the voltage unit is preset to 0.4, the apparatus may determine that a joint abnormality exists in the corresponding battery bank.

In another example, when the units of the first measurement value and the second measurement value are resistance, the difference between the first measurement value and the second measurement value may be calculated as 0.05. For example, when the threshold value for the resistance unit is preset to 0.04, the apparatus may determine that a joint abnormality exists in the corresponding battery bank.

In some embodiments, when the battery bank inspected for joint abnormality does not satisfy the conditions of operation S550, the apparatus may repeat steps S510 to S560 for another battery bank.

As described above, according to the method of inspecting a joint according to the embodiment of the disclosure, after the battery cells are all connected, it is possible to inspect whether the joint condition of the wire bonding in a non-physical, non-destructive manner.

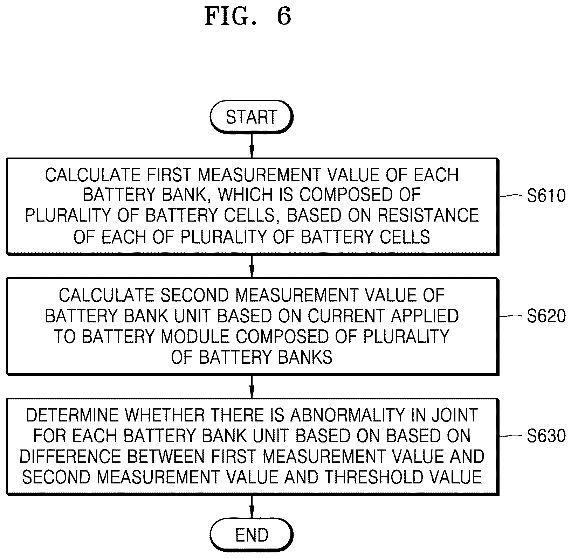

FIG. 6 is a flowchart illustrating an example of a method of inspecting a joint according to an embodiment.

Referring to FIG. 6, the method of inspecting a joint may include S610 to S630. The method described below may be performed by the processor 210.

In operation S610, an apparatus for inspecting a joint may calculate a first measurement value of a battery bank unit, which includes a plurality of battery cells, based on the resistance of each of the plurality of battery cells.

In an embodiment, the apparatus may obtain the resistance of each of the plurality of battery cells, and may calculate a measurement value related to at least one of voltage and resistance of the battery bank unit based on the resistance.

In an embodiment, the resistance may be a resistance measured at a point in time when the plurality of battery cells are interconnected and constitute a battery bank.

In operation S620, the apparatus may calculate a second measurement value of a battery bank unit based on current applied to a battery module including a plurality of battery banks.

In an embodiment, the apparatus may measure a voltage of a battery bank unit and, based on the measured voltage, calculate a resistance of the battery bank unit.

In an embodiment, the apparatus may measure a current for at least one of the plurality of battery cells constituting the battery bank, and may calculate a measurement value related to at least one of voltage and resistance of the battery bank unit based on the measured current.

In operation S630, the apparatus may determine whether there is an abnormality in the joint for each battery bank unit based on a difference between the first measurement value and the second measurement value and a threshold value (e.g., the difference compared to the threshold value).

In an embodiment, the units of the first measurement value and the second measurement value may be a same voltage or a same resistance (e.g., they may be the same type of measurement value).

In an embodiment, the threshold value may include a value preset by a user based on experimentation.

In an embodiment, the unit of the threshold value may be determined based on the units of the first measurement value and the second measurement value, and the threshold value may include a value preset by the user based on the determined unit.

Although the disclosure has been described with reference to the embodiments illustrated in the drawings, these embodiments are merely exemplary. One of ordinary skill in the art will understand that various modifications and equivalent embodiments will be apparent from this description. Accordingly, the inventive concept is not limited to such embodiments, but rather to the broader scope of the presented claims and various obvious modifications and equivalent arrangements.

The steps of all methods described herein can be performed in any suitable order unless otherwise indicated herein or otherwise clearly contradicted by context. Embodiments of the disclosure are not limited to the described order of the operations. The use of any and all examples, or exemplary language (e.g., "such as") provided herein, is intended merely to better illuminate the disclosure and does not pose a limitation on the scope of the disclosure unless otherwise claimed. Also, numerous modifications and adaptations will be readily apparent to one of ordinary skill in the art without departing from the scope of the disclosure.

Therefore, technical ideas of the disclosure are not limited to the embodiments described above, and it is intended that not only the appended claims, but also all modifications equivalent to claims, should be considered to fall within the scope of the disclosure.

A bus bar is electrically connected to the battery cells. Among the methods for electrically connecting the bus bar and the battery cells, ultrasonic wire bonding (WB) may be applied. Ultrasonic wire bonding is a method of electrically connecting the battery cells and the bus bar by applying the principle of friction welding using a molten metal such as aluminum. In order to ensure favorable quality of ultrasonic wire bonding, securing the two base metals in place is highly important. If movement of the base metals occurs during the ultrasonic bonding process, there is a problem in that bonding defects are likely to occur.

According to embodiments, it is possible to non-destructively inspect for abnormalities in wire bonding joints between battery cells and bus bars.

Example embodiments have been disclosed herein, and although specific terms are employed, they are used and are to be interpreted in a generic and descriptive sense only and not for purpose of limitation. In some instances, as would be apparent to one of ordinary skill in the art as of the filing of the present application, features, characteristics, and/or elements described in connection with a particular embodiment may be used singly or in combination with features, characteristics, and/or elements described in connection with other embodiments unless otherwise specifically indicated. Accordingly, it will be understood by those of skill in the art that various changes in form and details may be made without departing from the scope of the present invention as set forth in the following claims.

## Claims

1. A method of inspecting a joint, the method comprising:
calculating a first measurement value of a battery bank unit (21, 22, 23), which includes a plurality of battery cells (31, 32, 33, 34), based on a resistance of each of the plurality of battery cells;
calculating a second measurement value of the battery bank unit based on current applied to a battery module (10) including a plurality of battery banks; and
determining whether there is an abnormality in a joint for the battery bank unit based on a difference between the first measurement value and the second measurement value, the difference being compared to a threshold value.

2. The method as claimed in claim 1, wherein calculating the first measurement value comprises:
obtaining the resistance of each of the plurality of battery cells (31, 32, 33, 34); and
calculating a measurement value related to at least one of voltage and resistance of the battery bank unit (21, 22, 23) based on a measured current and/or a measured voltage, respectively.

3. The method as claimed in claim 2, wherein the resistance is measured at a point in time when the plurality of battery cells (31, 32, 33, 34) are interconnected and constitute the battery bank unit (21, 22, 23).

4. The method as claimed in any one of claims 1 to 3, wherein calculating the second measurement value comprises:
measuring a voltage of the battery bank unit (21, 22, 23), resulting in a measured voltage; and
calculating a resistance of the battery bank unit (21, 22, 23) based on the measured voltage.

5. The method as claimed in any one of claims 1 to 3, wherein calculating the second measurement value comprises:
measuring a current for at least one of the plurality of battery cells (31, 32, 33, 34), resulting in a measured current; and
calculating a measurement value related to at least one of voltage and resistance of the battery bank unit (21, 22, 23) based on the measured current.

6. The method as claimed in any one of claims 1 to 5, wherein the first measurement value and the second measurement value are a same voltage or a same resistance.

7. The method as claimed in any one of claims 1 to 6, wherein the threshold value comprises a predetermined value.

8. An apparatus (200) for inspecting a joint, the apparatus comprising:
at least one memory (220); and
at least one processor (210), wherein the processor is configured to:
calculate a first measurement value of a battery bank unit (21, 22, 23), which includes a plurality of battery cells (31, 32, 33, 34), based on a resistance of each of the plurality of battery cells,
calculate a second measurement value of the battery bank unit (21, 22, 23) based on current applied to a battery module (10) including a plurality of battery bank units, and
determine whether there is an abnormality in a joint for one of the plurality of battery bank units (21, 22, 23) based on a difference between the first measurement value and the second measurement value, the difference being compared to a threshold value.

9. The apparatus as claimed in claim 8, wherein the processor (210) is further configured to:
obtain the resistance of each of the plurality of battery cells (31, 32, 33, 34); and
calculate a measurement value related to at least one of voltage and resistance of the battery bank unit (21, 22, 23) based on a measured current and/or a measured voltage, respectively.

10. The apparatus as claimed in claim 9, wherein the resistance is measured at a point in time when the plurality of battery cells (31, 32, 33, 34) are interconnected and constitute the plurality of battery bank units (21, 22, 23).

11. The apparatus as claimed in any one of claims 8 to 10, wherein the processor (210) is further configured to:
measure a voltage of the battery bank unit (21, 22, 23), resulting in a measured voltage; and
calculate a resistance of the battery bank unit (21, 22, 23) based on the measured voltage.

12. The apparatus as claimed in any one of claims 8 to 11, wherein the processor (210) is further configured to:
measure a current for at least one of the plurality of battery cells (31, 32, 33, 34), resulting in a measured current; and
calculate a measurement value related to at least one of voltage and resistance of the battery bank unit (21, 22, 23) based on the measured current.

13. The apparatus as claimed in any one of claims 8 to 12, wherein units of the first measurement value and the second measurement value are a same voltage or a same resistance.

14. The apparatus as claimed in any one of claims 8 to 13, wherein the threshold value comprises a predetermined value.

15. A computer-readable recording medium having recorded thereon a program for causing a computer to execute the method as claimed in any one of claims 1 to 7.
